# EUROPÄISCHE PATENTSCHRIFT

(11) **EP 1 550 202 B1**
(45) Veröffentlichungstag und Bekanntmachung des Hinweises auf die Patenterteilung: **07.06.2006**
(21) Anmeldenummer: 03769207.6
(22) Anmeldetag: 19.09.2003
(51) Int. Cl.: H02N 2/18, G08C 17/02, H01L 41/113

(54) **ENERGIEAUTARKER ELEKTROMECHANISCHER FUNKSCHALTER**
ENERGY-AUTARCHIC ELECTROMECHANICAL RADIO SWITCH
COMMUTATEUR RADIO ELECTROMECANIQUE A AUTONOMIE ENERGETIQUE

(30) Priorität: 04.10.2002 DE 10246342; 02.12.2002 DE 10256156
(43) Veröffentlichungstag der Anmeldung: 06.07.2005
(73) Patentinhaber: EnOcean GmbH, 82041 Oberhaching (DE)
(72) Erfinder: GRASSL, Erwin, 82541 St. Heinrich (DE); SCHMIDT, Frank, 85604 Zorneding (DE)
(74) Vertreter: Epping - Hermann - Fischer
(86) Internationale Anmeldenummer: PCT/DE2003/003124
(87) Internationale Veröffentlichungsnummer: WO 2004/034560

(56) Entgegenhaltungen:
- WO-A-01/67580
- DE-A- 10 025 561
- DE-U- 29 712 270
- US-A- 5 844 516

## Beschreibung

Die Erfindung betrifft einen energieautarken elektromechanischen Funkschalter zum Beispiel als Installationsschalter.

Es sind Installationsschalter bekannt die drahtgebunden, die Spannungszufuhr zu einem Verbraucher unterbrechen oder öffnen. Ebenso bekannt ist aus DE 10063305 Cl die prinzipielle Möglichkeit der Realisierung energieautarker Funkschalter, welche ihre Energie aus der Betätigung des Schalters beziehen. Die Kraft und Geschwindigkeit der Betätigung ist dabei stets unterschiedlich und hat damit ebenso stets unterschiedliche Mengen an Energieausbeute zur Folge. Dies ist insbesondere dann von Bedeutung, wenn elektronische Schaltungen zur Erzeugung eines zu übertragenden Funksignals von dieser Energieversorgung abhängig sind.

Es sind Anwendungen gewünscht, bei denen aus ästhetischen oder funktionellen Gründen ein drahtloser Schalter erforderlich ist, der in Form und äußeren Erscheinungsbild einem Installationsschalter gleicht, oder zumindest sehr ähnlich ist.

Ein solchen drahtlosen Schalter zeigt die Druckschrift WO 01/67580 A2 mit einer Schaltwippe, einem Wandlerelement zur Wandlung von mechanischer in elektrische Energie, einer Totpunktmechanik und zumindest einer Elektronik zur Erzeugung und Absendung eines Funksignals, wobei mittels der Totpunktmechanik eine mechanische Verbindung zwischen der Schaltwippe und dem Wandlerelement gebildet ist. Eine durch die Schaltwippe eingebrachte mechanische Energie wird in der Totpunktmechanik bis zum Erreichen eines Wendepunkts gespeichert und nach dem Überschreiten des Wendepunkts wird die mechanische Energie an das Wandlerelement übertragen, wobei die Kraft und die Geschwindigkeit der damit erreichten Anregung des Wandlerelementes durch die Totpunktmechanik bestimmt ist. In der Offenbarung der WO 01/67580 A2 ist zur Energieübertragung eine Mechanik gezeigt, die mit der Schaltwippe in einer Richtung "gespannt wird", dabei wird die mechanische Energie in einer Feder oder einem dehnbaren Element gespeichert welche sich beim Erreichen eines Wendepunktes in entgegengesetzter Richtung entlädt, wobei eine Übertragung der mechanischen Energie auf das Wandlerelement erfolgt. Damit wird erreicht, dass die Anregung des Wandlerelementes abhängig von der Totpunktmechanik ist, und unabhängig von der Form der mechanisch auf die Schaltwippe eingebrachten Energie. Die WO 01/67580 A2 zeigt eine Totpunktmechanik mit nur einem Totpunkt der einen Bewegungsendpunkt einer gerichteten Be-wegung darstellt. Damit ist nur eine Schaltrichtung darstellbar.

Druckschrift DE 10025561 A1 zeigt einen energieautarken Hochfrequenzsender mit einem Wandlerelement und einer Elektronik zur Erzeugung und Absendung eines Funksignals.

Es ist die Aufgabe der Erfindung, einen energieautarken Funkschalter anzubieten, der gegenüber dem Stand der Technik flexibler einsetzbar ist.

Diese Aufgabe wird mit den Maßnahmen des Patentanspruchs 1 gelöst. Wobei ein energieautarker elektromechanischen Funkschalter zumindest ein Wandlerelement zur Umwandlung von mechanischer in elektrischer Energie aufweist, sowie zumindest ein Betätigungsfeld zum Einbringen der mechanischen Energie aufweist, sowie zumindest einem Sensor für jedes Betätigungsfeld zur Erkennung des Schaltbefehls aufweist, und zumindest einer Elektronik zur Erzeugung und Absendung eines Funksignals und zumindest einer Mechanik zur Umlenkung der durch das Betätigungsfeld eingebrachten Kräfte auf das Wandlerelement.

Die Erfindung stellt dabei eine Verbindung von Elektronik und Mechanik zu einem kompakten miniaturisierten Modul dar. Die Betätigung erfolgt durch Druckkraft auf einem oder mehrere Betätigungsfelder, wobei die mechanische Kraft über Hebel oder ähnliches umgeleitet und so an das Wandlerelement weitergegeben wird. Eine Betätigung, eines jeden Betätigungsfeldes, wirkt so auf das Wandlerelement, daß ausreichend Energie zu kurzzeitigem Betrieb der Elektronik und zur Erzeugung und Absendung eines Funksignals bereitgestellt wird. Das Wandlerelement ist dabei vorzugsweise ein piezoelektrischer Wandler. Es eignen sich auch elektrodynamische oder magnetostriktive Wandler sowie Kombinationen zweier oder mehrerer Wandler verschiedener physikalischen Prinzipien.

Dem Wandlerelement ist dabei eine Totpunktmechanik vorausgeschaltet, die bis zu einer Kippposition die über die Betätigungsfelder eingebrachte mechanische Energie aufnimmt beziehungsweise speichert und diese dann ab dieser Kippposition in Richtung des nächstliegenden Totpunktes, zum Beispiel durch Federkraft, abgibt und damit den Wandler betätigt. Das heißt, daß bei Krafteinwirkung zunächst Energie in einen mechanischen Speicher, vorzugsweise eine oder mehrere Federn, gesammelt wird, die sich bei Überschreiten des Wendepunktes rasch und unabhängig von der Geschwindigkeit der Betätigung und ebenso unabhängig von der Kraft der Betätigung auf das energiewandelnde Element, das Wandlerelement, überträgt. Auf diese Weise wird stets die gleiche Energiemenge, unabhängig von der Art der Betätigung des Betätigungsfeldes gewandelt.

Erfindungsgemäß ist jedem Betätigungsfeld ein Sensor zugeordnet, welcher nur bei Betätigung dieses Betätigungsfeldes anspricht. Vorzugsweise ist dieser Sensor ein elektromechanischer Kontakt, in Form einer flexiblen leitenden Matte, deren leitfähige Teile bei Betätigung Leiterbahnen auf einer Leiterplatte überbrücken. Es sind auch andere Schalterformen wie Mikrotaster, Miniaturlichtschranken oder Reedkontakte als Sensor möglich.

Die über das Wandlerelement mit Energie versorgte Elektronik registriert über den jeweiligen Sensor mit welchem Betätigungsfeld die Energie erzeugt wurde, und kodiert diese Information zusätzlich zu einer eindeutigen Kennung des Schalters und der Schaltrichtung des Betätigungsfeldes in ein Funktelegramm.

Jedes Betätigungsfeld das zum Beispiel als Tastwippe, als Schalterwippe oder als Tastfeld ausgeführt sein kann, regt die Mechanik, so an, daß sowohl das Drücken wie auch das Loslassen des Betätigungsfeldes das Wandlerelement anregt und damit Energie an die Elektronik liefert und damit ebenso ein Funktelegramm erzeugt wird. Demzufolge enthält das Funktelegramm nicht nur Informationen zur Identifikation des Funkschalters und des betätigten Betätigungsfeldes, sondern enthält darüber hinaus Informationen über die Richtung der Betätigung des Betätigungsfeldes. Eine Möglichkeit, die Richtung der Betätigung zu detektieren, ist eine Auswertung der Polarität der erzeugten Spannung an der Elektronik. Das Funktelegramm enthält also zum Beispiel in nicht abschließender Aufzählung folgende Informationen.
1. Eine Identifikationsnummer des Funkschalters.
2. Eine Kennung des Betätigungsfeldes.
3. Eine Information über die Richtung der Betätigung.

Im folgenden ist die Erfindung anhand von 7 Figuren näher beschrieben. Es zeigen:
- Figur 1: eine Ausführungsform des Funkschalters in einer perspektivischen Darstellung,
- Figur 2: eine Ausführungsform des Funkschalters in einer Schnittdarstellung,
- Figur 3: die mechanischen Komponenten zur Kraftübertragung in einer perspektivischen Darstellung
- Figur 4: die Komponenten aus Figur 3 mit elektronischen Komponenten,
- Figur 5: ein Wandlerelement mit Totpunktmechanik und Mitnehmer,
- Figur 6: das Wandlerelement mit Totpunktmechanik und Mitnehmer in einer Schnittdarstellung,
- Figur 7: das Wandlerelement mit Totpunktmechanik und Mitnehmer in einer weiteren Schnittdarstellung.

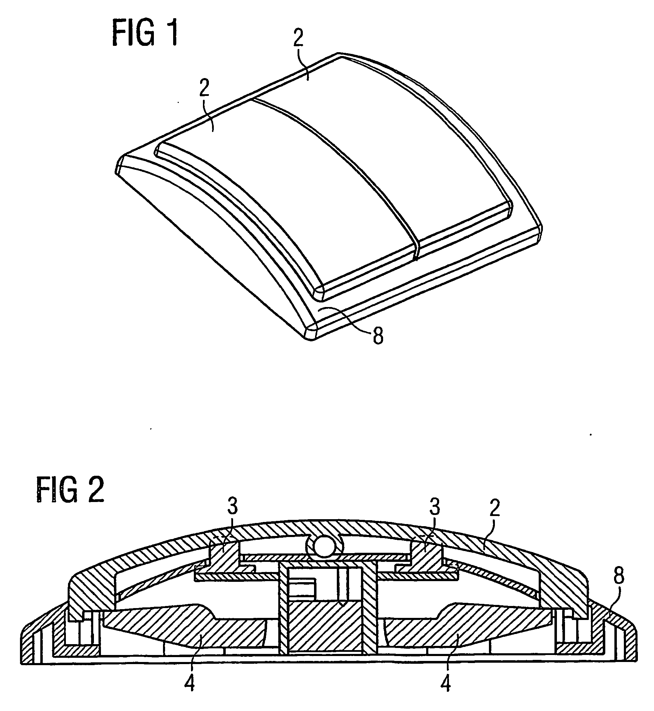

In Figur 1 ist ein erfindungsgemäßer Installationsschalter dargestellt in einer Ausführungsform mit zwei Betätigungsfeldern 2 die von einem Rahmen 8 umgeben sind. Diese beispielhafte Ausführungsform entspricht in Form und Design einem Installationsschalter.

Figur 2 zeigt die gleiche beispielhafte Ausführungsform in einer Schnittdarstellung, wobei der Schnitt in Längsrichtung durch eines der Betätigungsfelder 2 geführt ist. In dieser Ausführungsform sind die Betätigungsfelder 2 als Schaltwippen ausgebildet, die hier in ihrer Ruhestellung dargestellt, mittig gelagert sind. Das Betätigungsfeld 2 hat unmittelbaren mechanischen Kontakt zur Mechanik 4 und unmittelbaren Kontakt zu den Sensoren 3. Wird die Wippe auf einer Seite betätigt, so wird damit gleichzeitig die Mechanik 4 und der Sensor 3 betätigt beziehungsweise ausgelöst.

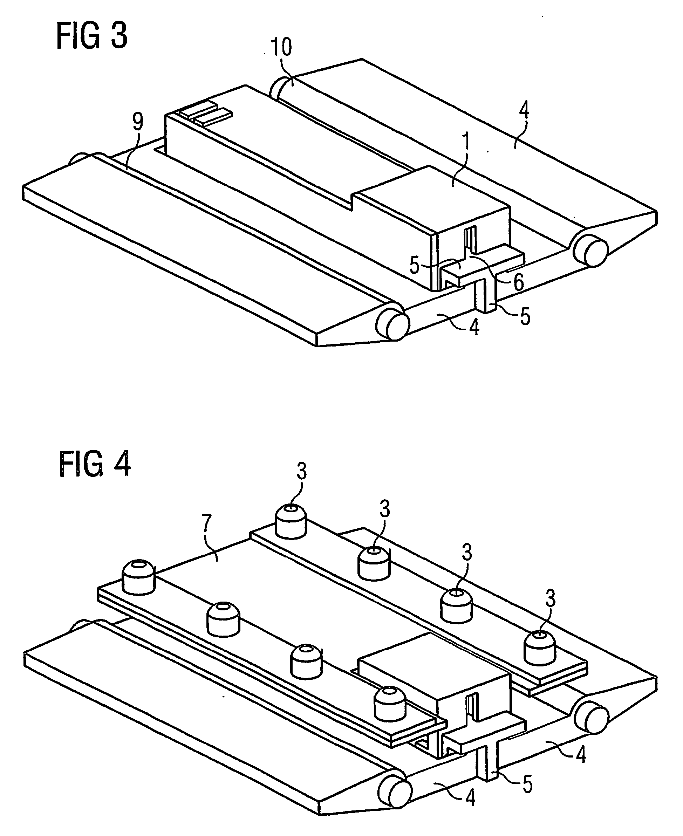

Die perspektivische Darstellung in Figur 3, die ausschließlich die Mechanik 4 zur Umlenkung der Kraft auf das Wandlerelement 1 zeigt, verdeutlicht die Funktionsweise dieser Mechanik 4. Das dargestellte Ausführungsbeispiel verfügt über ein Wandlerelement 1, das mittig in der Mechanik 4 angeordnet ist. Diese weist zwei Hebel 9 und 10 auf, die jeweils durch eine Bewegung beziehungsweise Betätigung der Betätigungsfläche bewegt werden. Dabei schieben die Hebel 9 und 10 den Mitnehmer 5 beim Drücken der Betätigungsfläche 2 nach oben, und lassen ihn beim Loslassen der Betätigungsfläche wieder zurückweichen.

Aufgrund der beidseitigen Anordnung der Hebel wird in jeder Betätigungsrichtung der Betätigungsflächen 4 der Mitnehmer 5 bewegt. Da der Mitnehmer 5 über eine Totpunktmechanik 6 zur Anregung des Wandlerelements 1 beiträgt, ist bei jeder Betätigung des Betätigungsfeldes 2 die Energieversorgung einer Elektronik 7 sichergestellt.

Figur 4 zeigt die eben beschriebene Mechanik in Verbindung mit den elektronischen Komponenten. Es sind dies
- die Elektronik 7 zur Erzeugung und Absendung eines Funksignals sowie
- die Sensoren 3 zur Detektion des betätigten Betätigungsfeldes und gegebenenfalls zur Detektion der Betätigungsrichtung.

Zur Spannungsversorgung der Elektronik 7 besteht ein elektrischer Kontakt zwischen dem Wandlerelement 6 und der Elektronik 7.

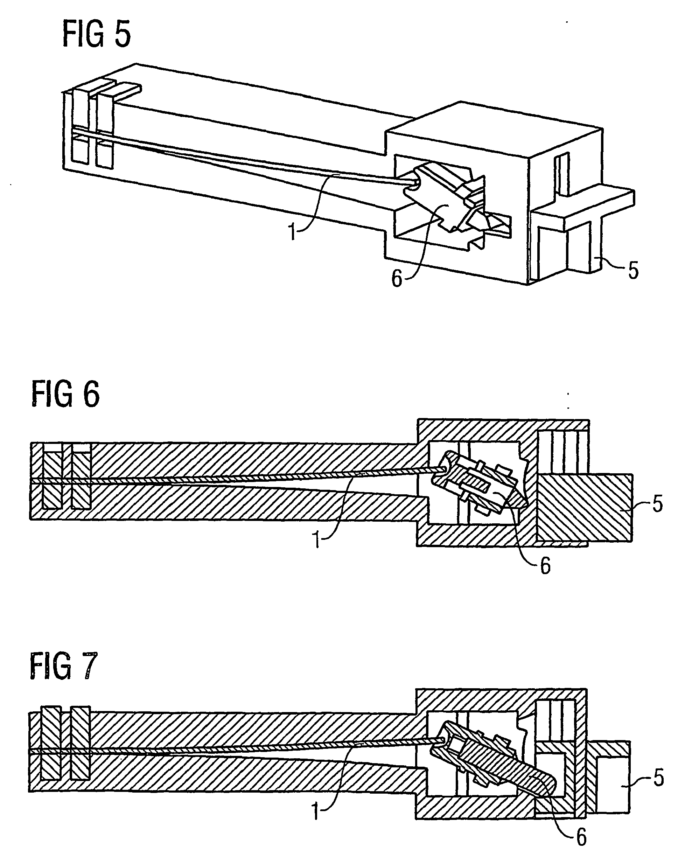

Die perspektivische Darstellung der Figur 5 zeigt die Totpunktmechanik 6 die das Wandlerelement 1 betätigt. Anhand der vorhergehenden Figuren wurde die Form der Betätigung des Mitnehmers 5 dargestellt. Nun ist anhand der Figuren 5 bis 7 die Übertragung der mechanischen Energie durch den Mitnehmer 5 auf das Wandlerelement 1 beschrieben.

Wird der Mitnehmer 5 bewegt, so speichert die Totpunktmechanik 6 in Verbindung mit dem Wandlerelement 1 und dessen Federkraft sowie gegebenenfalls weiteren Federelementen zunächst diese mechanische Energie. Wenn die Totpunktmechanik 6 einen Kipppunkt erreicht, erfolgt anschließend eine Energieabgabe in Richtung des nächstliegenden Totpunktes und damit in vorbestimmter Weise. Unabhängig von Geschwindigkeit, Dauer und Kraft der ursächlich einwirkenden mechanischen Betätigung, erfolgt eine Energieübertragung in stets der gleichen Form, Kraft und Dauer auf das Wandlerelement 1. Damit ist sichergestellt, daß die durch das Wandlerelement 1 erzeugte elektrische Energie stets konstant ist.

## Patentansprüche

1. Energieautarker elektromechanischer Funkschalter oder Funktaster mit
- zumindest einer Schaltwippe,
- zumindest einem Wandlerelement (1) zur Wandlung von mechanischer- in elektrische Energie,
- zumindest einer Totpunktmechanik (6) und
- zumindest einer Elektronik (7), die mit dem Wandlerelement (1) elektrisch verbunden ist, zur Erzeugung und Absendung eines Funksignals,
- zumindest ein Betätigungsfeld (2), mit zumindest einem Sensor (3) pro Betätigungsfeld (2),
- zumindes einer Mechanik (4) zur Umlenkung der durch die Schaltwippe eingebrachten Kraft auf die Totpunktmechanik,
wobei Mittels der Totpunktmechanik (6) eine mechanische Verbindung zwischen der Schaltwippe (2) und dem Wandlerelement (1) gebildet ist und eine durch die Schaltwippe (2) eingebrachte mechanische Energie in der Totpunktmechanik (6) bis zum Erreichen eines Wendepunkts gespeichert wird und nach dem Überschreiten des Wendepunkts die mechanische Energie an das Wandlerelement (1) übertragen wird, wobei die Kraft und die Geschwindigkeit der damit erreichten Anregung des Wandlerelements (1) durch die Totpunktmechanik (6) bestimmt ist,
**dadurch gekennzeichnet, dass**
die Totpunktmechanik (6) einen oberen Totpunkt und einen unteren Totpunkt aufweist, der jeweils einen Bewegungsendpunkt einer gerichteten Bewegung der Totpunktmechanik (6) bildet und wobei der Wendepunkt zwischen den Totpunkten angeordnet ist und die Totpunktmechanik (6) das Wandlerelement (1) in der Bewegungsrichtung der Energiespeicherung anregt.

2. Energieautarker elektromechanischer Funkschalter nach Patentanspruch 1,
**dadurch gekennzeichnet, daß**
ein Mitnehmer (5) eine gerichtete Bewegung der Schaltwippe auf die Totpunktmechanik (6) in gerichteter Weise überträgt.

3. Energieautarker elektromechanischer Funkschalter nach Patentanspruch 1 - 2,
**dadurch gekennzeichnet, daß**
die Totpunktmechanik (6) mit Federkraft das Wandlerelement (1) anregt.

4. Energieautarker elektromechanischer Funkschalter nach Patentanspruch 1 - 3,
**dadurch gekennzeichnet, daß**
die Anregung des Wandlerelements durch eine Federkraft des Wandlerelements (1) bestimmt ist.

5. Energieautarker elektromechanischer Funkschalter nach Patentanspruch 1 - 4,
**dadurch gekennzeichnet, daß**
das Wandlerelement (1) ein piezoelektrisches und/oder ein magnetodynamisches und/oder ein magnetostriktives Wandlerelement ist.

6. Energieautarker elektromechanischer Funkschalter nach Patentanspruch 1 - 5,
**dadurch gekennzeichnet, daß**
die Mechanik (4) zumindest einen Hebel (9 oder 10) aufweist, der die durch das Betätigungsfeld eingebrachte Arbeit auf den Mitnehmer (5) überträgt, der die Totpunktmechanik bewegt.

7. Energieautarker elektromechanischer Funkschalter nach einem der vorhergehenden Patentansprüche,
**dadurch gekennzeichnet, daß**
das die Schaltwippe in einer Mittenstellung eine Ruhelage aufweist und von dieser jeweils eine erste und eine zweite Betätigungsrichtung ausgeht.

8. Energieautarker elektromechanischer Funkschalter nach einem der vorhergehenden Patentansprüche,
**dadurch gekennzeichnet, daß**
jede Betätigung des Betätigungsfeldes (2) durch zumindest einen Sensor (3) detektiert wird und damit die Betätigungsrichtung des Betätigungsfeldes (2) erkannt und an die Elektronik (7) übermittelt wird.

9. Energieautarker elektromechanischer Funkschalter nach einem der vorhergehenden Patentansprüche,
**dadurch gekennzeichnet, daß**
die Elektronik (7) mit der durch das Wandlerelement (1) gelieferten Energie und der detektierten Betätigungsrichtung ein kodiertes Funksignal erzeugt.

10. Energieautarker elektromechanischer Funkschalter nach einem der vorhergehenden Patentansprüche,
**dadurch gekennzeichnet, daß**
für jede detektierte Betätigungsrichtung ein eindeutig kodiertes Funksignal erzeugt wird.

11. Energieautarker elektromechanischer Funkschalter nach nach einem der vorhergehenden Patentansprüche,
**dadurch gekennzeichnet, daß**
die Sensoren Schaltkontakte insbesondere Schaltmatten, Mikrotaster oder elektromagnetische oder elektrostatische getätigte Schaltkontakte sind.

12. Energieautarker elektromechanischer Funkschalter nach einem der vorhergehenden Patentansprüche,
**dadurch gekennzeichnet, daß**
das eindeutig kodierte Funksignal eine Kennung des Funkschalters und/oder des Betätigungsfeldes und/oder der Betätigungsrichtung enthält.

## Claims

1. Energy-autonomous electromechanical radio switch or radio pushbutton having
- at least one rocker switch,
- at least one transducer element (1) for converting mechanical to electrical energy,
- at least one dead-centre mechanism (6),
- at least one electronic system (7), which is electrically connected to the transducer element (1), for generating and emitting a radio signal,
- at least one actuating panel (2), having at least one sensor (3) per actuating panel (2), and
- at least one mechanism (4) for deflecting the force introduced by the rocker switch onto the dead-centre mechanism,
a mechanical connection between the rocker switch (2) and the transducer element (1) being formed by means of the dead-centre mechanism (6), and a mechanical energy introduced by the rocker switch (2) being stored in the dead-centre mechanism (6) until a turning point is reached, and, once the turning point has been exceeded, the mechanical energy being transmitted to the transducer element (1), the force and the speed of the excitation, which is thus achieved, of the transducer element (1) being determined by the dead-centre mechanism (6), **characterized in that** the dead-centre mechanism (6) has an upper dead centre and a lower dead centre, which each form a movement end point of a directed movement of the dead-centre mechanism (6), and the turning point being arranged between the dead centres, and the dead-centre mechanism (6) exciting the transducer element (1) in the movement direction of the energy store.

2. Energy-autonomous electromechanical radio switch according to Patent Claim 1, **characterized in that** a driver (5) transfers a directed movement of the rocker switch to the dead-centre mechanism (6) in a targeted manner.

3. Energy-autonomous electromechanical radio switch according to Patent Claims 1 - 2, **characterized in that** the dead-centre mechanism (6) excites the transducer element (1) with spring force.

4. Energy-autonomous electromechanical radio switch according to Patent Claims 1 - 3, **characterized in that** the excitation of the transducer element is determined by a spring force of the transducer element (1).

5. Energy-autonomous electromechanical radio switch according to Patent Claims 1 - 4, **characterized in that** the transducer element (1) is a piezoelectric and/or a magnetodynamic and/or a magnetostrictive transducer element.

6. Energy-autonomous electromechanical radio switch according to Patent Claims 1 - 5, **characterized in that** the mechanism (4) has at least one lever (9 or 10), which transfers the work introduced by the actuating panel to a driver (5), which moves the dead-centre mechanism.

7. Energy-autonomous electromechanical radio switch according to one of the preceding patent claims, **characterized in that** the rocker switch has a rest position in a central position and in each case a first and a second actuating direction starts from this central position.

8. Energy-autonomous electromechanical radio switch according to one of the preceding patent claims, **characterized in that** each actuation of the actuating panel (2) is detected by at least one sensor (3), and the actuating direction of the actuating panel (2) is thus detected and is transmitted to the electronic system (7).

9. Energy-autonomous electromechanical radio switch according to one of the preceding patent claims, **characterized in that** the electronic system (7) generates an encoded radio signal using the energy supplied by the transducer element (1) and the detected actuating direction.

10. Energy-autonomous electromechanical radio switch according to one of the preceding patent claims, **characterized in that** a uniquely encoded radio signal is generated for each detected actuating direction.

11. Energy-autonomous electromechanical radio switch according to one of the preceding patent claims, **characterized in that** the sensors are switching contacts, in particular switching mats, micro pushbuttons or electromagnetically or electrostatically actuated switching contacts.

12. Energy-autonomous electromechanical radio switch according to one of the preceding patent claims, **characterized in that** the uniquely encoded radio signal contains, for example: an identifier for the radio switch and/or the actuating panel and/or the actuating direction.

## Revendications

1. Interrupteur radio ou bouton radio électromécanique à autonomie d'énergie, comportant
- au moins une bascule de commutation,
- au moins un élément de convertisseur (1) pour la conversion d'énergie mécanique en énergie électrique,
- au moins une mécanique à point mort (6) et
- au moins une électronique (7) qui est reliée électriquement à l'élément de convertisseur (1) pour générer et envoyer un signal radioélectrique,
- au moins une zone d'actionnement (2) comportant au moins un capteur (3) par zone d'actionnement (2),
- au moins une mécanique (4) permettant de transmettre à la mécanique à point mort, la force appliquée par la bascule,
une liaison mécanique étant formée entre la bascule de commutation (2) et l'élément de convertisseur (1) au moyen de la mécanique à point mort (6) et une énergie mécanique, appliquée par la bascule de commutation (2), étant accumulée dans la mécanique à point mort (6) jusqu'à atteindre un point de basculement et, après dépassement du point de basculement, l'énergie mécanique est transférée à l'élément de convertisseur (1), la force et la vitesse de l'activation ainsi obtenue de l'élément de convertisseur (1) étant déterminées par la mécanique à point mort (6),
**caractérisé en ce que** la mécanique à point mort (6) comporte un point mort supérieur et un point mort inférieur qui forment chacun un point d'extrémité d'un déplacement orienté de la mécanique à point mort (6), le point de basculement étant situé entre les points morts et la mécanique à point mort (6) activant l'élément de convertisseur (1) dans le sens de déplacement de l'accumulation d'énergie.

2. Interrupteur radio électromécanique à autonomie d'énergie selon la revendication 1, **caractérisé en ce qu'**un entraîneur (5) transmet de façon orientée un déplacement orienté de la bascule de commutation à la mécanique à point mort (6).

3. Interrupteur radio électromécanique à autonomie d'énergie selon la revendication 1 ou 2, **caractérisé en ce que** la mécanique à point mort (6) active l'élément de convertisseur (1) par une force élastique.

4. Interrupteur radio électromécanique à autonomie d'énergie selon l'une des revendications 1 à 3, **caractérisé en ce que** l'activation de l'élément de convertisseur est déterminée par une force élastique de l'élément de convertisseur (1).

5. Interrupteur radio électromécanique à autonomie d'énergie selon l'une des revendications 1 à 4, **caractérisé en ce que** l'élément de convertisseur (1) est un élément de convertisseur piézo-électrique et/ou un élément de convertisseur magnétodynamique et/ou un élément de convertisseur magnéto-strictif.

6. Interrupteur radio électromécanique à autonomie d'énergie selon l'une des revendications 1 à 5, **caractérisé en ce que** la mécanique (4) comporte au moins un levier (9 ou 10) qui transmet à l'entraîneur (5) qui déplace la mécanique à point mort le travail accumulé par la zone d'actionnement.

7. Interrupteur radio électromécanique à autonomie d'énergie selon l'une des revendications précédentes, **caractérisé en ce que** la bascule de commutation comporte dans une position moyenne une position de repos, à partir de laquelle elle se déplace dans un premier sens d'actionnement et dans un deuxième sens d'actionnement.

8. Interrupteur radio électromécanique à autonomie d'énergie selon l'une des revendications précédentes, **caractérisé en ce que** tout actionnement de la zone d'actionnement (2) est détecté par au moins un capteur (3) et reconnaît ainsi le sens d'actionnement de la zone d'actionnement (2) et le transmet à l'électronique (7).

9. Interrupteur radio électromécanique à autonomie énergie selon l'une des revendications précédentes, **caractérisé en ce que** l'électronique (7) génère un signal radioélectrique codé par l'énergie délivrée par l'élément de convertisseur (1) et par le sens d'actionnement détecté.

10. Interrupteur radio électromécanique à autonomie d'énergie selon l'une des revendications précédentes, **caractérisé en ce qu'**un signal radioélectrique codé de façon univoque est généré pour chaque sens d'actionnement détecté.

11. Interrupteur radio électromécanique à autonomie d'énergie selon l'une des revendications précédentes, **caractérisé en ce que** les capteurs sont des contacts de commutation notamment des treillis de commutation, des microboutons et des contacts à actionnement électromagnétique ou électrostatique.

12. Interrupteur radio électromécanique à autonomie d'énergie selon l'une des revendications précédentes, **caractérisé en ce que** le signal radioélectrique codé de façon univoque contient une caractéristique de l'interrupteur radio et/ou de la zone d'actionnement et/ou du sens d'actionnement.
